# FASCICULE DE BREVET EUROPEEN

(11) **EP 0 333 563 B1**
(45) Date de publication et mention de la délivrance du brevet: **26.05.1993**
(21) Numéro de dépôt: 89400659.2
(22) Date de dépôt: 09.03.1989
(51) Int. Cl.: H02H 3/087

(54) **Dispositif de commande de l'alimentation électrique d'une charge en circuit intégré de puissance "intelligent"**
Steueranordung für eine Belastung in einer integrierten intelligenten Leistungs schaltung
Electric power supply control unit for a charge in an intellegent integrated power circuit

(30) Priorité: 16.03.1988 FR 8803374
(43) Date de publication de la demande: 20.09.1989
(73) Titulaire: SIEMENS AUTOMOTIVE S.A., 31036 Toulouse Cédex (FR)
(72) Inventeur: Sicard, Thierry Michel Alain, F-31150 Fenouillet (FR)
(74) Mandataire: Fuchs, Franz-Josef, Dr.-Ing.

(56) Documents cités:
- DE-A- 3 243 467
- FR-A- 2 260 869

## Description

La présente invention est relative à un dispositif de commande de l'alimentation électrique d'une charge réalisé en circuit intégré de puissance "intelligent" et plus particulièrement, à un tel dispositif commandant l'alimentation d'une charge inductive.

On rassemble sous le nom de circuits intégrés de puissance "intelligents" (de l'expression anglo-saxonne "smart power integrated circuits"), des circuits intégrés rassemblant sur une même puce des fonctions logiques réalisées en technologie MOS ou bipolaires, par exemple, et au moins un composant de puissance DMOS ou bipolaire, par exemple. Diverses technologies de réalisation de tels circuits intégrés ont été développées, et celles-ci ont conduit à des produits tels que les circuits SMARTMOS de la société des Etats-Unis d'Amérique MOTOROLA, les produits en technologie S2P2 ou VIP de la société italienne SGS MICROELECTTRONICA ou les SMART SIPMOS de la société SIEMENS AG de la République Fédérale d'Allemagne.

Des tels circuits intégrés de puissance "intelligents" s'avèrent particulièrement bien adaptés à la résolution de problèmes qui se posent en électronique automobile. En effet, des fonctions telles que l'allumage, la commande du temps d'injection, la modulation de la pression dans les circuits de freinage font appel à des charges inductives dont l'alimentation doit être commandée par des transistors de puissance. Ces transistors de puissance sont eux-mêmes contrôlés par des circuits logiques à courants faibles que l'on peut intégrer, grâce à ces nouveaux circuits de puissance "intelligents", sur la même puce que le transistor de puissance qui commande l'alimentation de la charge inductive. Comme exemple de telles charges inductives, on peut citer le bobinage d'un injecteur ou celui d'une électrovanne modulatrice d'une pression d'un liquide de freinage dans un dispositif d'antiblocage des roues. On peut citer encore la bobine d'un circuit primaire d'allumage inductif.

Les circuits commandant de telles charges inductives dans un environnement automobile sont souvent équipés de moyens de diagnostic permettant de détecter, par exemple, une déconnexion ou un court-circuit accidentel de la charge inductive rendant celle-ci inopérante, ceci pour des raisons de sécurité, par exemple. Ces moyens comprennent des circuits électroniques qui surveillent la tension régnant aux bornes de la charge pour détecter par exemple, l'apparition éventuelle d'un court-circuit et déclencher des actions d'alerte ou correctrices adéquates.

Les fortes tensions négatives qui apparaissent aux bornes de la charge inductive lorsque le circuit d'alimentation de cette charge est ouvert par le transistor de puissance placé en série avec cette charge sont alors susceptibles de détériorer les composants du circuit de diagnostic. Si celui-ci comprend, par exemple, un amplificateur réalisé en technologie MOS, les tensions grille-source ou grille-drain maximales supportables par les transistors de cet amplificateur sont d'environ 20 volts.

Dans un environnement automobile, l'ouverture du circuit de la charge inductive fait couramment apparaître aux bornes de celle-ci des tensions négatives de l'ordre de 20 à 30 volts, pour décharger rapidement l'énergie stockée dans la charge, tensions qui sont susceptibles de détériorer les transistors MOS du circuit de diagnostic. Il faut donc intercaler entre la sortie de la charge et l'entrée de l'amplificateur un organe de protection de cet amplificateur.

La présente invention a pour but d'incorporer un tel organe de protection à un dispositif de commande d'une charge inductive réalisé en circuit intégré de puissance "intelligent".

La présente invention a aussi pour but de réaliser un tel dispositif dans lequel l'organe de protection est associé à des moyens de diagnostic de l'état d'une charge inductive pour les protéger des tensions engendrées par l'ouverture d'un circuit d'alimentation de cette charge.

On atteint ces buts de l'invention, ainsi que d'autres qui apparaîtront dans la suite, avec un dispositif de commande de l'alimentation électrique d'une charge, réalisé en circuit intégré de puissance "intelligent", comprenant un circuit sensible à la tension aux bornes de la charge, un circuit d'alimentation de la charge et un organe de protection installé entre une borne de la charge et une entrée du circuit sensible pour protéger celui-ci de surtensions développées aux bornes de la charge, caractérisé en ce que cet organe de protection est constitué par un transistor bipolaire "vertical" intégré au dispositif et connecté suivant le montage émetteur-suiveur sur l'entrée du circuit sensible de manière à opposer sa jonction émetteur-base, qui présente une tension inverse maximale de claquage Vebo, à une tension Vc de polarité déterminée ayant une valeur maximale inférieure à Vebo développée aux bornes de la charge pour éviter toute détérioration du circuit sensible.

Au dessin annexé, donné seulement à titre d'exemple:
- La figure 1 représente un schéma de principe d'un dispositif de commande d'une charge inductive, équipé de moyens de diagnostic d'un éventuel court-circuit de cette charge et d'un organe de protection suivant l'invention de ces moyens de diagnostic, contre des surtensions apparaissant aux bornes de la charge et,
- la figure 2 représente schématiquement en coupe une partie de la structure interne d'un circuit intégré de puissance "intelligent" adapté à la mise en oeuvre du dispositif de commande de la figure 1, protégé suivant l'invention.

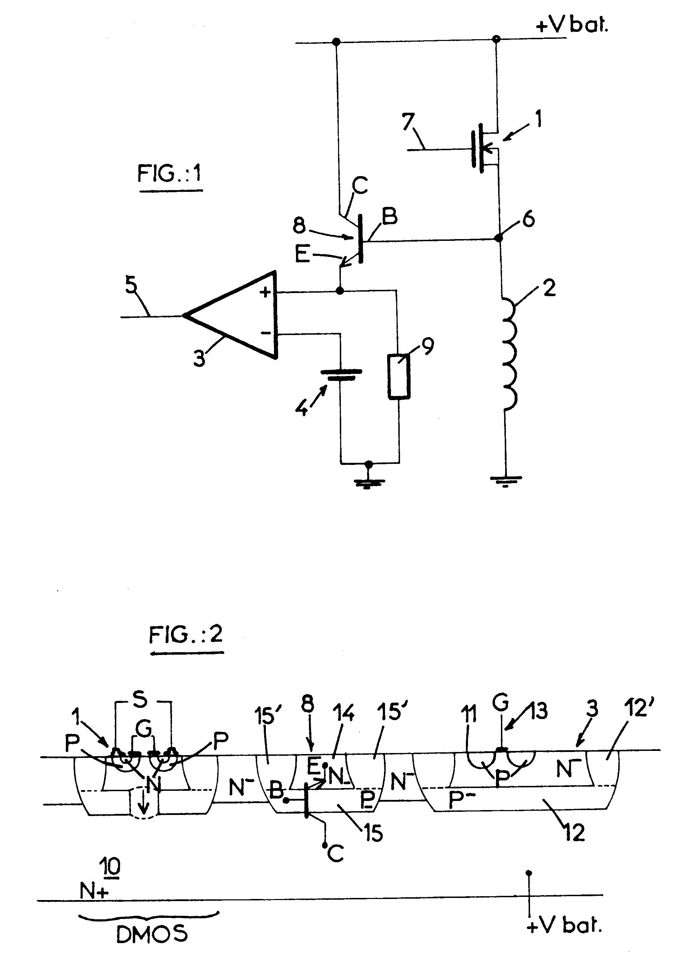

On se réfère à la figure 1 où le dispositif représenté comprend un transistor "vertical" de puissance 1, en technologie DMOS (ou TMOS suivant la terminologie adoptée par la société MOTOROLA) par exemple, dont le circuit drain-source est placé en série avec une charge inductive 2, entre la borne positive + Vbat d'une source d'énergie électrique et la masse. Dans l'une des applications d'électronique automobile mentionnées plus haut, cette source d'énergie électrique est une batterie embarquée et la masse est celle du véhicule. La charge inductive peut être alors constituée par le bobinage d'un injecteur commandant la quantité de carburant admise dans un ou des cylindres du moteur du véhicule. Ce peut être aussi le bobinage d'une électrovanne modulatrice de la pression d'un fluide de freinage formant partie d'un dispositif d'antiblocage des roues du véhicule, le bobinage du primaire d'un circuit d'allumage, etc ... De tels dispositifs sont ordinairement commandés par des signaux élaborés dans un boîtier électronique incorporant un ou plusieurs micro-processeurs, à partir de signaux d'entrée divers, représentatifs du régime du moteur, de la pression d'admission, de la vitesse des roues du véhicule, etc ... En plus de l'élaboration de ces signaux de commande, le boîtier exécute des fonctions de diagnostic concernant l'état de fonctionnement des capteurs ou des actuateurs (électrovannes, injecteurs, etc ...). Entre autres signaux de diagnostic, le boîtier est informé de l'existence éventuelle d'un court-circuit d'une des charges inductives envisagées ci-dessus, court-circuit qui empêche bien sûr l'actuateur équipé de cette charge de fonctionner correctement. Un signal représentatif d'une telle situation permet au boîtier de déclencher des actions de correction, permettant de maintenir une sécurité minimale de fonctionnement des équipements du véhicule, par exemple.

On détecte un éventuel court-circuit de la charge 2 en comparant une tension de référence à une tension prélevée aux bornes de la charge, lorsque le transistor 1 conduit. S'il y a court-circuit, la tension aux bornes est pratiquement nulle. On détecte cette situation à l'aide par exemple d'un circuit sensible tel qu'un amplificateur différentiel 3 monté en comparateur, qui reçoit sur son entrée non-inverseuse un signal significatif de la tension aux bornes de la charge 2 et sur l'entrée inverseuse un signal de tension de référence établi par exemple, à l'aide d'un générateur de tension 4 connecté entre cette entrée et la masse. Quand, lors d'un diagnostic de l'état de la charge 2, la tension sur l'entrée non-inverseuse de l'amplificateur est inférieure à la tension de référence, le niveau logique du signal présent sur la sortie 5 de l'amplificateur 3 bascule. Ce basculement du signal est perçu par le boîtier électronique comme représentatif d'un état de court-circuit de la charge 2. Des actions correctrices sont alors éventuellement déclenchées par le boîtier.

Dans un mode de réalisation du dispositif suivant l'invention, l'amplificateur 3 est réalisé avec des transistors MOS dont la tension maximum admissible grille-source ou grille-drain est d'environ 20 volts. Dans les applications d'électronique automobile mentionnées plus haut, la tension sur la borne 6 commune au transistor 1 et à la charge 2 peut descendre à des valeurs négatives Vc de l'ordre de 20 à 30 volts, au moment d'un blocage du transistor MOS 1, obtenu par l'application sur sa grille 7 d'un signal de tension approprié émis par le boîtier électronique qui commande la charge inductive ou selfique 2. Il convient alors d'isoler l'entrée non-inverseuse de l'amplificateur 3 de telles tensions négatives qui pourraient endommager les transistors MOS formant partie de cet amplificateur.

Pour ce faire on pourrait penser intercaler la jonction émetteur-base d'un organe de protection constitué par un transistor bipolaire 8, de type NPN et monté en émetteur-suiveur, entre la charge 2 et l'entrée inverseuse de l'amplificateur. La base B du transistor 8 est alors connectée à la borne 6, le collecteur C est relié à la ligne + Vbat de la source d'alimentation, en l'occurence la batterie du véhicule, et l'émetteur E est connecté à l'entrée non-inverseuse de l'amplificateur 3, une résistance de charge 9 étant connectée entre la masse et le collecteur du transistor 8.

Comme on l'a vu plus haut un blocage du transistor MOS 1, déclenché par un signal appliqué sur sa grille 7, provoque la décharge de l'énergie électromagnétique stockée dans la bobine 2. Il apparaît alors sur la base B du transistor 8 une tension négative. Si celle-ci est inférieure à la tension inverse maximum Vebo supportable par la jonction émetteur-base du transistor 8, cette jonction empêche l'application de cette tension négative à l'entrée non-inverseuse de l'amplificateur 3, et donc toute détérioration des transistors MOS de cet amplificateur par une tension négative qui serait supérieure aux tensions grille-source ou grille-drain supportables par ces transistors.

Cependant, la valeur de la tension inverse de claquage Vebo d'un transistor NPN classique ne dépasse pas 6 volts, ce qui est très inférieur aux tensions Vc de 20 à 30 volts mentionnées ci-dessus, observées couramment entre les bornes de la charge selfique 2, à l'ouverture de son circuit d'alimentation. De telles tensions ne sont donc pas supportées par la jonction émetteur-base d'un transistor NPN 8 classique qui ne peut jouer alors un rôle de protection vis-à-vis de l'amplificateur 3, que le transistor 8 NPN classique soit incorporé ou non à un circuit intégré de puissance "intelligent".

Suivant l'invention, on lève cette difficulté dans le cas d'un dispositif de commande d'une charge inductive réalisé en circuit intégré de puissance "intelligent" à isolation par jonction et structure verticale, en faisant usage d'un transistor bipolaire "parasite" défini dans la structure d'un tel circuit.

Ce transistor est caractérisé par une tension inverse Vebo qui peut atteindre 60 volts par exemple dans un circuit de puissance "intelligent" SMARTMOS de la société MOTOROLA précitée. Une telle tension inverse protège ainsi efficacement les transistors MOS de l'amplificateur 3.

On comprendra mieux l'invention en se référant à la figure 2 du dessin où l'on a représenté schématiquement une coupe d'une partie de la structure d'un circuit intégré de puissance "intelligent" à isolation par jonction et structure verticale, circuit qui met en oeuvre la présente invention.

Par comparaison à la structure d'un circuit intégré classique, un circuit de puissance "intelligent" comprend essentiellement une couche supplémentaire 10 de silicium de type N, par exemple N+, formant substrat, ce substrat étant connecté à la borne positive +Vbat d'une source d'énergie électrique telle qu'une batterie d'un véhicule automobile. Au-dessus de ce substrat on trouve une couche de silicium de type N, par exemple N-, obtenue par croissance épitaxiale. Dans une région 11 de cette couche, isolée par une couche enterrée 12 de type P et des murs d'isolation 12' de même type obtenu obtenus par diffusion, on peut implanter divers composants électroniques classiques, en particulier des transistors MOS ou bipolaires utiles à la réalisation de la partie "commande" ou de la partie "diagnostic" du circuit de commande de charge selfique de la figure 1. A titre d'exemple, on a représenté un transistor 13 MOS canal P implanté dans cette région 11.

La structure de circuit intégré représentée à la figure 2 comprend aussi un transistor de puissance DMOS (ou TMOS suivant la terminologie adoptée par la société MOTOROLA) qui correspond au transistor 1 de la figure 1. C'est le grand avantage des circuits intégrés de puissance "intelligents" tels que celui schématisé à la figure 2, que de comprendre à la fois une partie de puissance (le transistor DMOS par exemple) et une partie "courants faibles" correspondant à des circuits opérant sur de "petits" signaux pour former des signaux utiles à la commande de la partie de puissance. C'est la raison de leur emploi en électronique automobile pour la commande de charges inductives.

Suivant la présente invention, l'amplificateur 3 du circuit de diagnostic de l'état de la charge inductive 2 du dispositif de la figure 1 est protégé des fortes tensions négatives apparaissant aux bornes de cette charge, à la coupure du courant dans la charge, par un organe de protection constitué d'un transistor "vertical" 8 défini dans l'épaisseur du circuit intégré représenté. A la figure 2 on a représenté les diverses jonctions de ce transistor et, en surimpression, les connexions classiques d'un transistor pour indiquer comment les diverses régions de ce transistor sont connectées au dispositif de la figure 1.

Le transistor représenté est du type NPN. Le substrat 10 de type N+ du circuit intégré constitue le collecteur C du transistor, qui est ainsi connecté à la ligne +Vbat de l'alimentation. L'émetteur E est constitué par un caisson 14 de la couche N- formée par croissance épitaxiale, ce caisson 14 étant séparé du substrat par une couche enterrée 15 et des murs d'isolation 15' de type P, obtenus par diffusion et qui constituent la base du transistor 8. On comprend que le courant du circuit émetteur-collecteur du transistor 8 traverse alors le circuit intégré perpendiculairement aux faces externes du circuit intégré, comme c'est le cas d'ailleurs du courant commandé par le transistor 1 de puissance, du type DMOS (d'où expression "transistor vertical"). On remarquera aussi que le caisson 14 est isolé de la borne positive +Vbat de la source d'énergie électrique par la base du transistor 8, à la jonction base-émetteur de ce transistor "vertical". On dit alors en raccourci que la technologie "verticale" utilisée met en oeuvre une isolation par jonction.

Avec le montage émetteur-suiveur de la figure 1 mis en oeuvre dans un circuit intégré de puissance "intelligent" du type décrit ci-dessus, on observe que la jonction base-émetteur du transistor 8 constituée dans la structure du circuit intégré représentée à la figure 2 présente une tension inverse Vebo de l'ordre de 60 volts, du fait du faible dopage N- de l'émetteur 14 et du faible dopage P- de la base 15. Cette tension inverse est alors très supérieure aux tensions inverses, de l'ordre de 20 à 30 volts, que l'on observe aux bornes des charges inductives utilisées en électronique automobile. L'invention propose donc de protéger des circuits à courants faibles implantés dans un circuit intégré de puissance "intelligent" à l'aide de transistors "verticaux" isolés par jonction et implantés comme représenté à la figure 2, dans des régions 14 et 15 de faible dopage.

Lorsqu'une borne d'une charge selfique commandée par un circuit de puissance "intelligent" doit être reliée à une partie "courants faibles" telle que l'amplificateur 3 d'un circuit de diagnostic associé à la charge selfique 2 du circuit de la figure 1, le montage en émetteur-suiveur du transistor 8 de la figure 2 protège efficacement l'entrée non-inverseuse de cet amplificateur contre des tensions négatives jusqu'à environ 60 volts, ce qui est largement suffisant pour empêcher toute détérioration du dispositif de diagnostic lors des décharges des bobines d'actuateurs utilisées en électronique automobile. On fait ainsi, suivant l'invention, un usage inattendu d'un effet transistor intrinsèquement contenu dans la structure multi-couches d'un circuit intégré de puissance "intelligent" à structure verticale et isolation par jonction, du type SMARTMOS par exemple, suivant la dénomination utilisée par la société MOTOROLA.

Bien entendu, l'invention n'est pas limitée au mode de réalisation décrit et représenté qui n' a été donné qu'à titre d'exemple. L'homme de métier pourra adapter le dispositif de commande décrit à des types de transistors et à des structures de circuit intégré de puissance "intelligent" autres que celle décrite, sans sortir du cadre de l'invention. Egalement, l'invention n'est pas limitée à la protection d'un circuit de diagnostic de l'état du court-circuit d'une charge inductive. Elle est applicable à la protection de tout sous-circuit susceptible d'être détérioré par une surtension apparaissant dans un circuit de puissance "intelligent", due par exemple à une impulsion négative induite sur la sortie du transistor de commande de l'alimentation d'une charge d'un type quelconque.

## Revendications

1. Dispositif de commande de l'alimentation électrique d'une charge, réalisé en circuit intégré de puissance "intelligent", comprenant un circuit (3) sensible à la tension aux bornes de la charge (2), un circuit d'alimentation (1) de la charge et un organe de protection (8) installé entre une borne de la charge et une entrée du circuit sensible pour protéger celui-ci de surtensions développées aux bornes de la charge, caractérisé en ce que cet organe de protection est constitué par un transistor bipolaire "vertical" (8) intégré au dispositif et connecté suivant le montage émetteur-suiveur sur l'entrée du circuit sensible de manière à opposer sa jonction émetteur-base, qui présente une tension inverse maximale de claquage Vebo, à une tension Vc de polarité déterminée ayant une valeur maximale inférieure à Vebo développée aux bornes de la charge (2) pour éviter toute détérioration du circuit sensible.

2. Dispositif conforme à la revendication 1, caractérisé en ce que le transistor bipolaire "vertical" (8) de protection est du type NPN, le collecteur (C) du transistor (8) étant constitué par le substrat (10) de type N du circuit intégré de puissance "intelligent", substrat connecté à la borne positive d'une source d'alimentation du circuit et de la charge, l'émetteur (E) du transistor (8) étant constitué par un caisson (14) superficiel de type N du circuit, caisson isolé du substrat par une région (15, 15') de type P constituant la base (B) du transistor (8).

3. Dispositif conforme à la revendication 2, caractérisé en ce que la charge (2) est une charge inductive dont l'alimentation est commandée par un transistor (1) de puissance, cette charge développant une tension négative Vc sur la base du transistor bipolaire (8) lors du blocage du transistor (1), cette tension négative Vc étant inférieure en valeur absolue à la tension inverse maximale Vebo du transistor bipolaire (8).

4. Dispositif conforme à la revendication 3, caractérisé en ce que le transistor (1) de puissance est du type DMOS "vertical".

5. Dispositif conforme à l'une quelconque des revendications 1 à 4, caractérisé en ce que le circuit (3) sensible à la tension aux bornes de la charge est un circuit de diagnostic de l'état de cette charge.

6. Dispositif conforme à la revendication 5, caractérisé en ce que le circuit de diagnostic est sensible à une éventuelle mise en court-circuit de la charge.

7. Dispositif conforme à la revendication 6, caractérisé en ce que le circuit de diagnostic comprend un amplificateur différentiel (3) monté en comparateur, l'entrée non-inverseuse de cet amplificateur étant connectée à l'émetteur du transistor (8) de protection alors que l'entrée inverseuse est portée à une tension de référence, l'amplificateur délivrant sur sa sortie (5) un signal significatif de l'existence d'un court-circuit de la charge (2) quand la tension sur l'entrée non-inverseuse tombe en dessous de la tension de référence.

8. Dispositif conforme à l'une quelconque des revendications 5 à 7, caractérisé en ce que le circuit de diagnostic est réalisé en technologie MOS.

## Patentansprüche

1. Steuervorrichtung für die elektrische Versorgung einer Last in Form einer "intelligenten" integrierten Leistungsschaltung, mit einer Schaltung (3), die gegen die Spannung an den Klemmen der Last (2) empfindlich ist, einer Schaltung (1) zur Versorgung der Last und einem Schutzelement (8), das zwischen eine Klemme der Last und einen Eingang des spannungsempfindlichen Schaltung geschaltet ist, um diese gegen zu hohe Spannungen an den Klemmen der Last zu schützen, dadurch gekennzeichnet, daß das Schutzelement von einem "vertikalen" bipolaren Transistor (8) gebildet wird, der in die Steuervorrichtung integriert ist und in Emitter-Folgeschaltung am Eingang der spannungsempfindlichen Schaltung so angeschlossen ist, daß sein Emitter-Basis-Übergang, der eine maximale inverse Durchbruchspannung Vebo besitzt, einer Spannung Vc einer vorgegebenen Polarität gegengeschaltet ist, welche einen maximalen Wert hat, der kleiner als die Spannung Vebo an den Klemmen der Last (2) ist, um eine Schädigung der spannungsempfindlichen Schaltung zu vermeiden.

2. Vorrichtung nach Anspruch 1, dadurch gekennzeichnet, daß der "vertikale" bipolare Schutztransistor (8) ein NPN-Transistor ist, wobei der Kollektor (C) des Transistors (8) von dem als N-Leiter ausgebildeten Substrat (10) der "intelligenten" integrierten Leistungsschaltung gebildet wird, welches Substrat mit der positiven Klemme einer Versorgungsquelle der Schaltung und der Last verbunden ist, und wobei der Emitter (E) des Transistors (8) von einem Oberflächenstreifen (14) der Leitfähigkeit N der Schaltung gebildet wird, welcher gegenüber dem Substrat durch einen die Basis B des Transistors (8) bildenden Bereich (15, 15') der Leitfähigkeit P isoliert ist.

3. Vorrichtung nach Anspruch 2, dadurch gekennzeichnet, daß die Last (2) eine induktive Last ist, deren Versorgung durch einen Leistungstransistor (1) gesteuert wird, wobei diese Last eine negative Spannung (Vc) an der Basis des bipolaren Transistors (8) während der Sperrung des Transistors (1) entwickelt, wobei diese negative Spannung (Vc) hinsichtlich ihres absoluten Wertes kleiner ist als die maximale inverse Spannung Vebo des bipolaren Transistors (8).

4. Vorrichtung nach Anspruch 3, dadurch gekennzeichnet, daß der Leistungstransistor (1) ein "vertikaler" DMOS-Transistor ist.

5. Vorrichtung nach einem der Ansprüche 1 bis 4, dadurch gekennzeichnet, daß die Schaltung (3), die gegen die Spannung an den Klemmen der Last empfindlich ist, eine Schaltung für die Diagnose des Zustandes dieser Last ist.

6. Vorrichtung nach Anspruch 5, dadurch gekennzeichnet, daß die Diagnoseschaltung gegen einen eventuellen Kurzschluß der Last empfindlich ist.

7. Vorrichtung nach Anspruch 6, dadurch gekennzeichnet, daß die Diagnoseschaltung einen Differentialverstärker (3) aufweist, der als Vergleichsstufe geschaltet ist, wobei der nicht invertierende Eingang dieses Verstärkers mit dem Emitter des Schutztransistors (8) verbunden ist, während an dem invertierenden Eingang eine Bezugsspannung anliegt, wobei der Verstärker an seinem Ausgang (5) ein das Vorhandensein eines Kurzschlusses der Last (2) anzeigendes Signal abgibt, wenn die Spannung an dem nicht invertierenden Eingang unter die Bezugsspannung abfällt.

8. Vorrichtung nach einem der Ansprüche 5 bis 7, dadurch gekennzeichnet, daß die Diagnoseschaltung in MOS-Technik hergestellt ist.

## Claims

1. Control device for the electrical power supply to a load, produced as an "intelligent" power integrated circuit, comprising a circuit (3) sensitive to the voltage at the terminals of the load (2), a power supply circuit (1) for the load and a protection member (8) installed between one terminal of the load and one input of the sensitive circuit in order to protect the latter from overvoltages developed at the terminals of the load, characterised in that this protection member consists of a "vertical" bipolar transistor (8) integrated into the device and connected in the emitter-follower configuration to the input of the sensitive circuit in such a way as to oppose its emitter-base junction, which has a maximum reverse breakdown of voltage Vebo, to a voltage Vc of defined polarity having a maximum value less than Vebo developed at the terminals of the load (2) in order to avoid any deterioration in the sensitive circuit.

2. Device in accordance with Claim 1, characterised in that the "vertical" bipolar protection transistor (8) is of the NPN type, the collector (C) of the transistor (8) consisting of the N-type substrate (10) of the "intelligent" power integrated circuit, a substrate connected to the positive terminal of a power supply source for the circuit and for the load, the emitter (E) of the transistor (8) consisting of an N-type surface casing (14) of the circuit, a casing insulated from the substrate by a P-type region (15, 15') constituting the base (B) of the transistor (8).

3. Device in accordance with Claim 2, characterised in that the load (2) is an inductive load whose power supply is controlled by a power transistor (1), this load developing a negative voltage Vc on the base of the bipolar transistor (8) when the transistor (1) is turned off, this negative voltage Vc being less in absolute value than the maximum reverse voltage Vebo of the bipolar transistor (8).

4. Device in accordance with Claim 3, characterised in that the power transistor (1) is of the "vertical" DMOS type.

5. Device in accordance with any one of Claims 1 to 4, characterised in that the circuit (3) which is sensitive to the voltage at the terminals of the load is a diagnostic circuit for the status of this load.

6. Device in accordance with Claim 5, characterised in that the diagnostic circuit is sensitive to a possible short-circuiting of the load.

7. Device in accordance with Claim 6, characterised in that the diagnostic circuit comprises a differential amplifier (3) configured as a comparator, the non-inverting input of this amplifier being connected to the emitter of the protection transistor (8) while the inverting input is taken to a reference voltage, the amplifier delivering on its output (5) a signal signifying the existence of a short circuit in the load (2) when the voltage on the non-inverting input falls below the reference voltage.

8. Device in accordance with any one of Claims 5 to 7, characterised in that the diagnostic circuit is produced in MOS technology.
